# EUROPEAN PATENT APPLICATION

(11) **EP 1 265 469 A2**
(43) Date of publication of application: **11.12.2002**
(21) Application number: 02011615.8
(22) Date of filing: 28.05.2002
(51) Int. Cl.: H05K 3/12

(54) **Solder paste printing method and apparatus for printing solder paste on a board on which wiring patterns are formed**

(30) Priority: 01.06.2001 JP 2001166910
(71) Applicant: NEC CORPORATION, Tokyo (JP)
(72) Inventor: Sakai, Hiroshi, Minato-ku, Tokyo (JP); Suzuki, Motoji, Minato-ku, Tokyo (JP); Igarashi, Makoto, Nagaoka-shi, Niigata (JP); Tanaka, Akihiro, Nakakubiki-gun, Niigata (JP)
(74) Representative: VOSSIUS & PARTNER

(57) **Abstract**

The solder paste printing method of the present invention mounts a solder paste containing therein as a solder material a Sn-Zn system solder on a mask, and urges the solder paste to make rolling over the mask from one end thereof toward the opposite thereof by means of a squeegee to thereby fill the solder paste into apertures formed in the mask. At this time, by maintaining moisture contained in the atmosphere surrounding the solder paste at a value equal to or less than a predetermined value, as the solder paste is suppressed from causing an increase in the viscosity thereof due to the reaction with the moisture in the surrounding atmosphere during the solder paste printing process, the rolling ability of the solder paste during the printing process can be kept, and attachment of the solder paste to the squeegee can be prevented.

## Description

The present invention relates to solder paste printing method and apparatus for printing solder paste on a board formed thereon with wiring patterns.

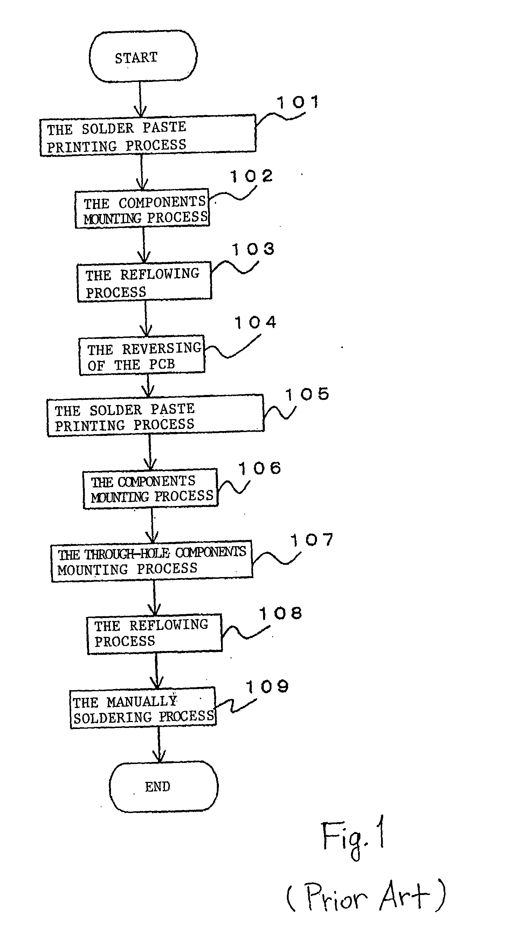

Hitherto, soft soldering is usually employed for fixedly mounting electronic components on a printed circuit board (it will be referred to as a PCB). A description of an example of the method of mounting electronic components by the use of a soft solder is provided hereinbelow with reference to Fig. 1. Here, the description of a case where soldering is applied by the known reflowing technique on both surfaces of a PCB, respectively, will be provided.

First, a metal mask provided with apertures at positions corresponding to land portions of a PCB is used for printing solder paste on the land portions (Step 101). Subsequently, electronic components such as chips, QFP (Quad Flat Package), SOP (Small Outline Package) and so on are mounted on the PCB, so that the electric terminals and leads of these electronic components are mounted onto the printed solder paste (Step 102). Thereafter, the PCB mounting thereon the electronic components is urged to pass through a high-temperature reflowing furnace so as to fuse the solder paste thereby soldering the electrodes of the electronic components to the land portions of the PCB (Step 103).

The described process permits completion of the mounting of the electronic components onto one of both surfaces of the PCB. Therefore, the PCB is subsequently reversed so that the other surface mounting thereon no electronic components is held upward (Step 104).

Subsequently, similarly to the described Steps 101 and 102, the printing of the solder paste (Step 105) and mounting of the electronic components (Step 106) are carried out. Thereafter, the components having their electric leads are inserted in the through-holes (Step 107). Then, similarly to the Step 103, the PCB is urged to pass through the furnace so as to complete the soldering of the components (Step 108).

Finally, some electronic components that are not able to withstand a high temperature in the reflowing furnace are subjected to the process for manually soldering these components to thereby complete mounting of the electronic components onto the PCB (Step 109).

In the above-described mounting method of the electronic components according to the known technology, solder paste containing therein solder of tin and lead (Sn-Pb) system is generally used. However, since the Sn-Pb system solder contains therein lead (Pb) that is a toxic heavy metal, unless electronic appliances after usage are adequately put on the discard, there has occurred such a problem that an adverse affect is provided on the global atmosphere. Taking this into consideration, in recent years, in order to solve the described problem to thereby prevent the environmental pollution beforehand, employment of a Pb-free solder containing therein no lead component has long been desired.

A tin and silver (Sn-Ag) system solder is typically known as the Pb-free solder. Since the property of the silver (Ag) is stable, when the Sn-Ag system solder is used for the mounting of the electronic components in lieu of the Sn-Pb system solder, it can ensure identical degree of reliability with the conventional mounting method. Nevertheless, compared with the fact that the melting point of the Sn-Pb system solder is at about 183 °C, the melting point of the Sn-Ag system solder is at about 220 °C, which is rather high. Therefore, the conventional mounting apparatus and method having employed the Sn-Pb system solder cannot be directly applied when the Sn-Ag system solder is employed.

If the Sn-Ag system solder having the melting point of as high as 220 °C is fused in the reflowing furnace to carry out the soldering of the electronic components, the temperature of the components could occasionally be more than 240 °C. Since the heatproof temperature of the general electronic components is at approximately 230 °C, when the Sn-Ag system solder is employed for mounting the electronic components, such a problem must be encountered that the heatproof temperature of various sorts of electronic components should be raised.

There is another Pb-free solder different from the Sn-Ag solder having the above-mentioned high melting point, i.e., a tin-Zinc (Sn-Zn) system solder. Since the melting point of the Sn-Zn system solder is at approximately 197 °C, when the Sn-Zn system solder is employed for the mounting of electronic components, the conventional equipments and electronic components can be directly employed without any change to them.

Nevertheless, when the Sn-Zn system solder is compared with the conventionally employed Sn-Pb system solder, there are problems such that the Zinc (Zn) is apt to be oxidized, and the wettability of the Sn-Zn system solder is rather poor. Accordingly, when the mounting of the electronic components is conducted by the direct use of the
conventional equipments and the conventional mounting method, it cannot be ensured that the mounting reliability is equivalent to the conventional one.

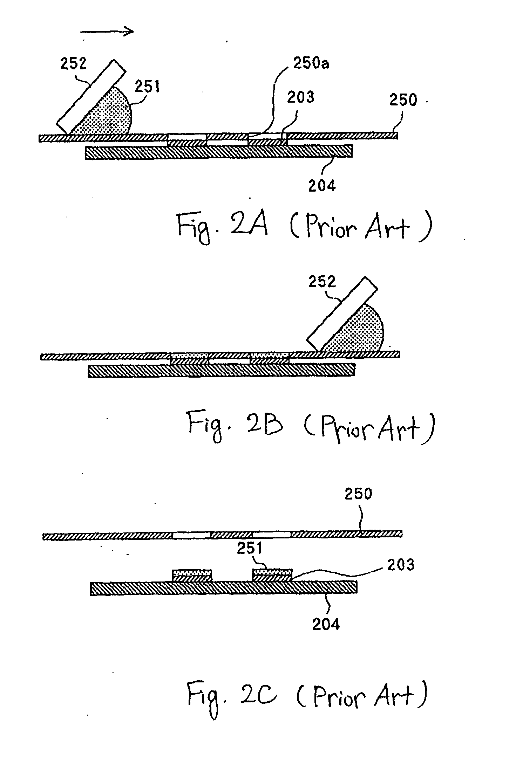

At this stage, the printing process of the above-described solder paste will be described with reference to Figs. 2A through 2C.

First, as shown in Fig. 2A, onto board 204, printing mask 250 is positioned and mounted so that respective apertures 250a of printing mask 250 are in correspondence with respective lands 203. Subsequently, a predetermined amount of solder paste 251 is placed on printing mask 250 mounted on board 204, and as shown in Fig. 2B, squeegee 252 is used for urging solder paste 251 to perform rolling over the surface of printing mask 250 from an end of the surface to the opposite end.

While solder paste 251 is rolling over the surface of printing mask 250, it is impressed into respective apertures 250a by the aid of squeegee 252 so as to fill up apertures 250a. Then, as shown in Fig. 2C, when printing mask 250 is separated away from board 204, a predetermined amount of solder paste 251 is printed on each of lands 203 of board 204, and thus the printing process of the solder paste is terminated.

With the solder paste containing therein the conventionally employed Sn-Pb system solder, the above-described printing process for the solder paste proceeds under such atmosphere that the temperature and humidity are at about 27 °C and 60 %, respectively. Thus, relatively thick moisture prevails in the atmosphere, and accordingly, if the flux component metamorphoses under a circumstance such that the solder paste is apt to be moistened, the lead (Pb) per se is a stable metal, and as a result, the Pb does not increase viscosity thereof due to reacting with the flux component for a short time. Therefore, the printing of the solder paste can be executed without causing any problem.

On the other hand, in the case of the solder paste containing therein the Sn-Zn system solder, the reaction of the flux component, which metamorphoses due to being moistened, with the zinc (Zn) that is an active metal proceeds for a short period of time, and accordingly the viscosity of the solder paste increases and is degraded. The degradation of the solder paste occurs in approximately three hours since the commencement of the printing process of the solder paste.

When the solder paste increases in its viscosity to become sticky, the rolling property thereof on the printing mask is lowered, and the solder paste is apt to be attached to the squeegee. Thus, during the impressing of the solder paste into the apertures of the printing mask by the aid of the squeegee, the solder paste fails to be sufficiently filled in the apertures and as a result, there is a possibility of causing a failure in the printing. Therefore, with the time lapse of about three hours after the commencement of the printing process of the solder paste, the solder paste needs to be replaced with fresh one.

Further, during the printing process of the solder paste, when the material of the solder, especially the zinc (Zn), is oxidized by the reaction with an oxygen contained in the atmosphere, wettability of the solder material is degraded. As a result, many solder balls are generated during the mounting process of the electronic components.

An object of the present invention is to provide solder paste printing method and apparatus, which are capable of suppressing an increase in viscosity of the solder paste during the printing process of the solder paste, and also suppressing deterioration of wettability of the solder due to oxidation thereof during the printing process of the solder paste.

In accordance with an embodiment of the present invention, the solder paste printing method of the present invention mounts solder paste containing therein a Sn-Zn system solder as a solder material onto a mask, and permits the solder paste to make rolling over the mask from an end thereof toward the opposite end by means of a squeegee to thereby fill apertures in the mask with the solder paste, with moisture contained in the atmosphere surrounding the solder paste being maintained at a moisture level equal to or less than a predetermined value in parallel.

In accordance with another embodiment of the present invention, the solder paste printing apparatus of the present invention is provided with a moisture regulating means for maintaining moisture contained in the atmosphere surrounding a solder paste containing therein, as a solder material, a Sn-Zn system solder and mounted on a mask placed in position on a printed circuit board, at a moisture level equal to or less than a predetermined value.

According to the present invention, since the moisture contained in the atmosphere surrounding the solder paste is regulated so as to maintain at a moisture level equal to or less than the predetermined moisture, an increase in the viscosity of the flux in the solder paste, which is caused by the reaction with the moisture in the surrounding atmosphere during the solder paste printing process, is well suppressed, and therefore the rolling ability of the solder paste can be kept adequate during the printing process. Further, attachment of the solder paste to the squeegee can be prevented, so that occurrence of any defective printing may be prevented.

The moisture may be equal to or less than 10 g/m³.

Further, an atmosphere surrounding the solder paste may be produced by the nitrogen gas (N₂). Thus, an amount of oxygen gas (O₂) contained in the atmosphere can be obviously reduced in comparison with the case of the air atmosphere, and accordingly deterioration of the wettability of the solder material due to the oxidation thereof can be prevented.

The above and other objects, features, and advantages of the present invention will become apparent from the following description with reference to the accompanying drawings, which illustrate examples of the present invention.

### BRIEF DESCRIPTION OF THE DRAWINGS

Fig. 1 is a flow chart indicating an example of the mounting method of electronic components, in which the electronic components are mounted by the employment of a solder;
Figs. 2A through 2C are schematic views illustrating the printing process of a solder paste; and
Fig. 3 is a schematic view illustrating an embodiment of a solder paste printing apparatus according to the present invention.

### DESCRIPTION OF THE PREFERRED EMBODIMENT

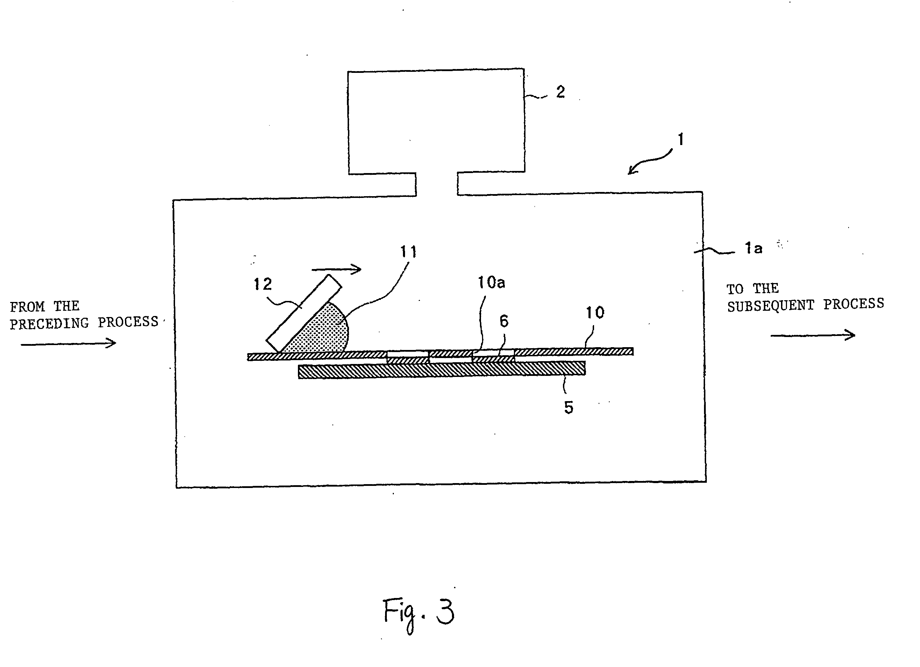

As illustrated in Fig. 3, solder paste printing apparatus 1 according to the present embodiment is provided with a printing cavity 1a capable of accommodating therein board 5 transferred from the preceding process and closed against the atmospheric environment, and a solder paste printing unit having mask 10 provided in printing cavity 1a and provided with apertures 10a and squeegee 12. In the present embodiment, the interior of printing cavity 1a is produced by an air atmosphere.

Further, solder paste printing apparatus 1 of the present embodiment is provided with moisture regulating unit 2 for maintaining moisture contained in the atmosphere within printing cavity 1a at a constant value. This moisture regulating unit 2 is constituted by, for example, a dehumidifier and a humidity sensor, and is constituted so as to constantly maintain moisture (g/m³) contained in the atmosphere within printing cavity 1a at a moisture value equal to or less than a predetermined value.

The printing method by the employment of solder paste printing apparatus 1 of the above-described constitution will be carried out as described below.

First, board 5 transferred from the preceding process is accommodated in printing cavity 1a. Subsequently, as explained by the reference to the illustration of Fig. 3, mask 10 is placed in position at a predetermined position on board 5 (the first process), and solder paste 11 containing therein a Sn-Zn system solder is mounted on mask 10. Then, solder paste 11 is permitted to roll over mask 10 from one end thereof to the opposite end by the aid of squeegee 12, so that solder paste 11 is filled in apertures 10a (the second process). Thereafter, mask 10 is separated away from board 5 (the third process), and thus solder paste 11 is printed onto lands 6 of board 5.

These first through third processes form the printing process of the solder paste. At this stage, during at least the second process of these processes, moisture regulating unit 2 conducts maintenance of moisture in the interior of printing cavity 1a at the predetermined value.

Thus, board 5 for which the printing process has completed is transferred to the subsequent processes, i.e., the mounting process for mounting electronic components and the reflowing process.

In the present embodiment, moisture in the atmosphere within printing cavity 1a during the above-described printing process is maintained by moisture regulating unit 2 at a level equal to or less than 10g/m³. If moisture equal to or less than 10 g/m³ is indicated by the relationship between temperature and humidity, it will correspond to conditions such that, for example, humidity is equal to or less 60% at the temperature of 19°C, equal to or less than 50% at 23°C, equal to or less than 40% at 27°C, and equal to or less than 30% at 32°C.

As described above, when the moisture in the atmosphere prevailing in the interior of printing cavity 1a during the printing process is regulated by moisture regulating unit 2 at a value equal to or less than 10 g/m³, reaction of the flux of solder paste 11 with the moisture in the surrounding atmosphere is made inactive during the solder paste printing process so as to suppress an increase in the viscosity of the flux, and as a result, the rolling ability of solder paste 11 during the printing process can be adequately maintained. Furthermore, attachment of solder paste 11 to squeegee 12 can be prevented, so that defective printing may be prevented from occurring.

Further, in the conventional printing process, although deterioration in the quality of the solder paste has occurred in approximately three hours after commencement of the printing process, according to the present embodiment, occurrence of deterioration in the solder paste quality can be prolonged to approximately 24 hours, so that life of solder paste 11 can be lengthened.

Further, in printing apparatus 1 of the present embodiment, the interior of printing cavity 1a may be prevailed by the nitrogen gas (N₂) atmosphere, and moisture contained in such atmosphere may be maintained at a value equal to or less than 10 g/m³. Thus, an increase in the viscosity of the flux contained in solder paste 11 which causes the defective printing may be prevented, and additionally in comparison with the case where the air atmosphere prevails in the interior of printing cavity 1a, the amount of oxygen gas (O₂) in the interior of printing cavity 1a can be surely reduced, and accordingly deterioration in the wettability of the solder material, especially the zinc (Zn), which could be caused by the oxidation of the solder material, can be prevented.

While preferred embodiments of the present invention have been described using specific terms, such description is for illustrative purpose only, and it is to be understood that changes and variations may be made without departing from the spirit or scope of the following claims.

## Claims

1. A solder paste printing method comprising:
a first process for mounting a mask having apertures corresponding to land portions of a printed circuit board, on said printed circuit board at a predetermined position thereof in a state where it is placed in position; a second process for mounting a solder paste containing therein as a solder material a tin-zinc (Sn-Zn) system solder on said mask and for permitting said solder paste to make rolling from one end of said mask toward the opposite end thereof by means of a squeegee, while maintaining moisture contained in the atmosphere surrounding said solder paste at a value equal to or less than a predetermined value, wherein said squeegee urges said solder paste to make rolling, to thereby fill said solder paste into said apertures; and
a third process for separating said mask away from said printed circuit board.

2. The solder paste printing method according to claim 1, wherein said moisture is equal to or less than 10 g/m³.

3. The solder paste printing method according to claim 1 or 2, wherein said atmosphere mainly comprises a nitrogen gas (N₂).

4. A solder paste printing apparatus comprising:
a mask having apertures corresponding to land portions of a printed circuit board;
a squeegee urging a solder paste containing therein as a solder material a tin-zinc (Sn-Zn) system solder and mounted on said mask, which is placed in position at a predetermined position on said printed circuit board to make rolling from one end of said mask toward the opposite end thereof; and
a moisture regulating means for maintaining moisture contained in the atmosphere surrounding said solder paste at a value equal to or less than a predetermined value.

5. The solder paste printing apparatus according to claim 4, wherein said moisture is equal to or less than 10 g/m³.

6. The solder paste printing apparatus according to claim 4 or 5, wherein said atmosphere mainly comprises a nitrogen gas (N₂).
